# EUROPEAN PATENT APPLICATION

(11) **EP 0 588 565 A2**
(43) Date of publication of application: **23.03.1994**
(21) Application number: 93307142.5
(22) Date of filing: 10.09.1993
(51) Int. Cl.: H01L 21/76

(54) **Semiconductor device and element separation method**

(71) Applicant: TEXAS INSTRUMENTS INCORPORATED, Dallas Texas 75265 (US)
(72) Inventor: Miyai, Yoichi, Inashiki-gun, Ibaraki-ken (JP); Tanoya, Noriyuki, Inashiki-gun, Ibaraki-ken (JP); Ogata, Yukihiro, Inashiki-gun, Ibaraki-ken (JP)
(74) Representative: Degwert, Hartmut, Dipl.-Phys.

(57) **Abstract**

The objective of the invention is to reduce or prevent a leakage current from the element region to the substrate and to greatly improve the element separation characteristic.

A number of element regions 12 and 12 are formed on p-type substrate 10 as n⁺⁻type wells, and on the top of the element separation region between said element regions 12 and 12, insulation film 14 composed of, for example, Si0₂ film and field electrode 16 composed of, for example, polysilicon are provided by being superimposed. Standard substrate voltage Vsub is applied to substrate 10. Voltage Vfp which essentially makes the surface of substrate 10 contacting insulation film 14 into the stored state is applied to field electrode 16.

## Description

### Detailed explanation of the invention

### Field of industrial application

Said invention pertains to a semiconductor device and element separation method in semiconductor integrated circuits.

### Conventional technology

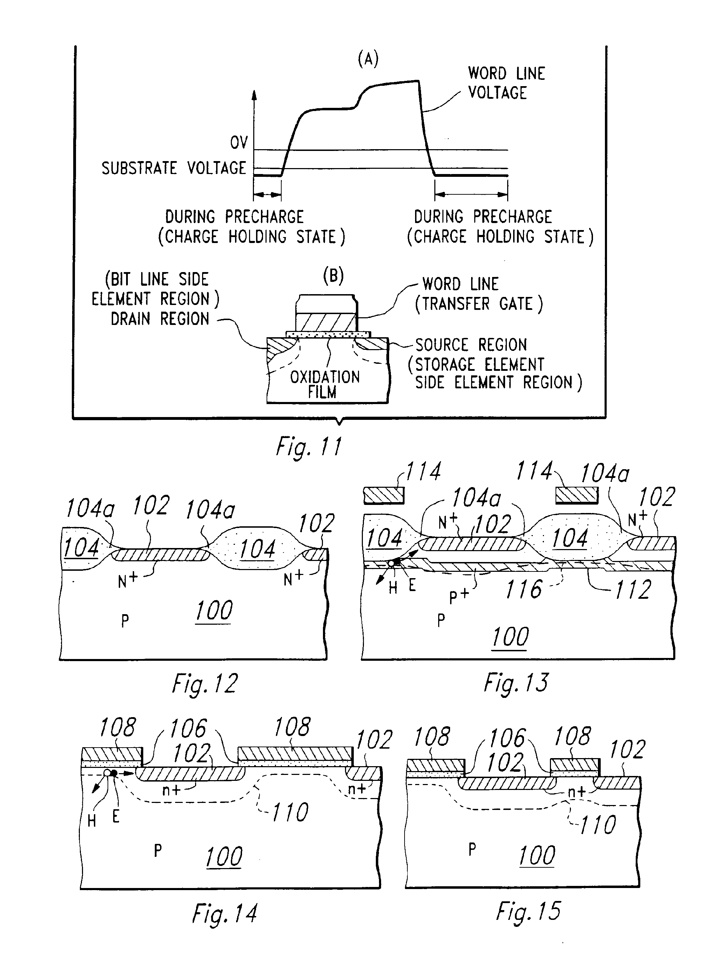

In semiconductor integrated circuits, it is necessary to insulate and separate the elements so that a number of elements formed within the substrate or on the substrate do not electrically interfere with each other. Conventionally, the element separation method used most often was the LOCOS (LOCal Oxidation of Silicon). The LOCOS method is a method which forms a thick oxide film by thermal oxidation in the part other than the element part on the substrate, namely, in the element separation region or the field region using Si₃N₄ film as the oxidation mask. The element separation structure based on the LOCOS method is shown in Figure 12. In this example, an n⁺⁻ type layer is formed on p-type semiconductor substrate 100 as element region 102, and oxidation film 104 formed by thermal oxidation using the LOCOS method is provided in the element separation region between said element regions 102 and 102.

That which was conventionally used often, other than the LOCOS method, is the field plate separation method. This element separation method is that which provides oxidation film 106 and field plate 108 by superimposing in the element separation region between element regions 102 and 102 on semiconductor substrate 100, then applying bias to field plate 108 so that depletion layer 110 which does not enter the inverse state, is formed in the element separation region as shown in Figure 14. For example, if semiconductor substrate 100 is a p-type and substrate voltage of about -2 V is applied, a voltage of about 0 V or about 1.65 V is applied to plate electrode 108.

### Problems the invention aims to solve

However, in the LOCOS method, Si0₂ infiltrates at the bottom side end part of the Si₃N₄ film, which masks element region 102 during the thermal oxidation, and a so-called bird's beak 104a is created in the end part of oxidation film 104 so it was difficult to obtain an element separation characteristic which satisfied the necessary specification of the next generation's super LSI. Firstly, there is the inconvenience of the effective area of element region 102 decreasing due to bird's beak 104a. In order to handle this, operation for narrowing the element separation region on the mask is generally executed by deforming the mask beforehand; however, when the spacing between elements is small, formation of the element separation region in the lithography processing step becomes impossible due to the resist pattern being too fine. Also, bird's beak 104a is created even in oxidation film 104; thus, the oxidation film thickness in this part becomes thin and the effective width of the element separation region become narrow. Also, when a MOS transistor is formed in element region 102, bird's beak 104a narrows the channel width by invading the transistor channel from both sides so a narrow channel effect is generated in which the threshold value of the transistor increases.

Furthermore, in the LOCOS method, there is the problem of a leakage current flowing into substrate 100 from element region 102 due to the following phenomenon intrinsic to LOCOS. In the LOCOS method, oxidation film 104 is grown while pressurizing with the end part of the SiₐN₄ film during the thermal oxidation so a great stress is generated near the base end part of bird's beak 104a. A leakage current flows to substrate 100 from element region 102 due to a crystal defect generated by said stress, and the stress itself causes an increase in the leakage current. Also, in the LOCOS method, so-called channel stop implantation is often used which installs layer 112 in which the same impurity as the substrate is selectively diffused near the substrate surface, makes the threshold value of the element separation region high, and forms a channel there as shown in Figure 13, but when the impurities of channel stop layer 112 and the impurities of element region 102 make contact near the end part of oxidation film 104, a leakage current flows to substrate 100 from element region 102. Also, in the element separation by the LOCOS method, depletion layer 116 is formed under oxidation film 104 due to the relation between the potential of substrate 100 and the potential of wiring 114 on oxidation film 104, and since a few carriers (electron E when substrate 100 is the p-type) out of the electron/hole pairs E and H generated in said depletion layer 116fiow into element region 102, a leakage current flows to substrate 100 from element region 102.

On the other hand, surface depletion layer 110 is formed in the element separation region as shown in Figure 14 in the conventional field plate element separation method so element/hole paris E and H are created in said depletion layer 110; thus, there was the problem of a leakage current in a few carriers (electron E when substrate 100 is the p-type) out of those flowing into element region 102. Also, when the spacing between elements becomes small, as shown in Figure 15, the narrow channel effect originating in depletion layer 110 becomes noticeable in the parasitic MOS of the element separation region and a sufficient separation resistance between the elements cannot be obtained.

Said invention aims to provide a semiconductor device and element separation method which greatly reduces or prevents a leakage current to the substrate from the element region, and moreover, greatly improves the element separation characteristic.

### Means for solving the problems

In order to achieve the objectives, the semiconductor device of said invention comprises a semiconductor region of the first conductive type is formed within said semiconductor region, source and drain regions of the second conductive type are formed within said semiconductor region, an insulation layer is formed between said source and drain regions which covers said semiconductor region, a gate electrode is formed on said insulation layer, and a means is made for arranging said first conductive type semiconductor region under said insulation layer into the stored state.

Also, the element separation method of said invention is constituted to provide an insulation film and electrode on said substrate between a number of semiconductor elements to be superimposed, and to select the potential of said electrode so that the surface of said substrate corresponding to said electrode is essentially made in the stored state, in an element separation method for electrically separating a number of semiconductor elements on one semiconductor substrate or within the substrate.

Also, so that the surface of said substrate in contact with said insulation film essentially becomes the stored state even when the potential of said electrode is a value close to the substrate potential, a charge with a polarity complying with the conductive type of said substrate is included in said insulation film or said electrode formed with a semiconductor with the same conductive type as that of said substrate.

In said invention, the insulation film and the electrode are superimposed on the substrate of the element separation region and the substrate surface of the element separation region is essentially controlled in the stored state so that a depletion layer is not physically formed. There is no need to form a thick oxidation film on the element separation region, like in the LOCOS method so stress is not generated in the end part of the oxidation film; thus, a leakage current does not occur in the end part of the element region. Also, a depletion layer does not exist in the substrate surface of the element separation region so electron/hole pairs are not generated; thus, a leakage current due to infiltration of a few carriers into the element region does not occur. Furthermore, in said invention, there is no restriction in the element separation characteristics originating in a bird's beak or narrow channel effect originating in the depletion on the substrate surface of the element separation region so it is possible, in principle, for the adjacent element regions to approach each other without making contact.

Reference will now be made by way of example to the accompanying drawings, in which:-
Figure 1 is a sectional figure which typically shows a cross-sectional structure of the semiconductor integrated circuit based on the element separation method of said invention;
Figure 2 is an energy band diagram showing the energy state near the substrate surface of the element separation region obtained by said invention;
Figure 3 is an energy band diagram showing the first method for making the substrate surface of the element separation region into the stored state in said invention;
Figure 4 is an energy band diagram showing the second method for making the substrate surface of the element separation region into the stored state in said invention;
Figure 5 is a figure which shows the flat band voltage characteristics based on the first and second method of said invention;
Figure 6 is a block diagram showing the voltage generating circuit used in the third method for making the substrate surface of the element separation region into the stored state in said invention;
Figure 7 is a figure showing an example of the test data shown by comparing the leakage characteristic and element separation resistance of a representative conventional element separation method and the element separation method of said invention;
Figure 8 is a top view typically showing a layout example for executing power feeding to the field electrode easily within the memory array based on said invention in a DRAM;
Figure 9 is a sectional figure showing an example which applied said invention to stack.in.trench.cells;
Figure 10 is a sectional figure showing an example which applied said invention to stacked cells;
Figure 11 is a figure showing the state of the substrate surface under the transfer gate and the control system of the word line voltage in the applied example of said invention in a MOS transistor of a DRAM;
Figure 12 is a sectional figure showing the element separation by the LOCOS method;
Figure 13 is a sectional figure showing the problems in the element separation by the LOCOS method;
Figure 14 is a sectional figure showing the element separation by the conventional field plate element separation method; and
Figure 15 is a sectional figure showing the element separation by the conventional field plate element separation method when the spacing between elements has been made small.

### Reference numerals

10...substrate, 12...element region, 14...insulation film, 16...field electrode, 30...substrate, 34...insulation film, 36...field electrode, 41...MOS transistor, 60...substrate, 80...insulation film, 82...field electrode, 84...contact part.

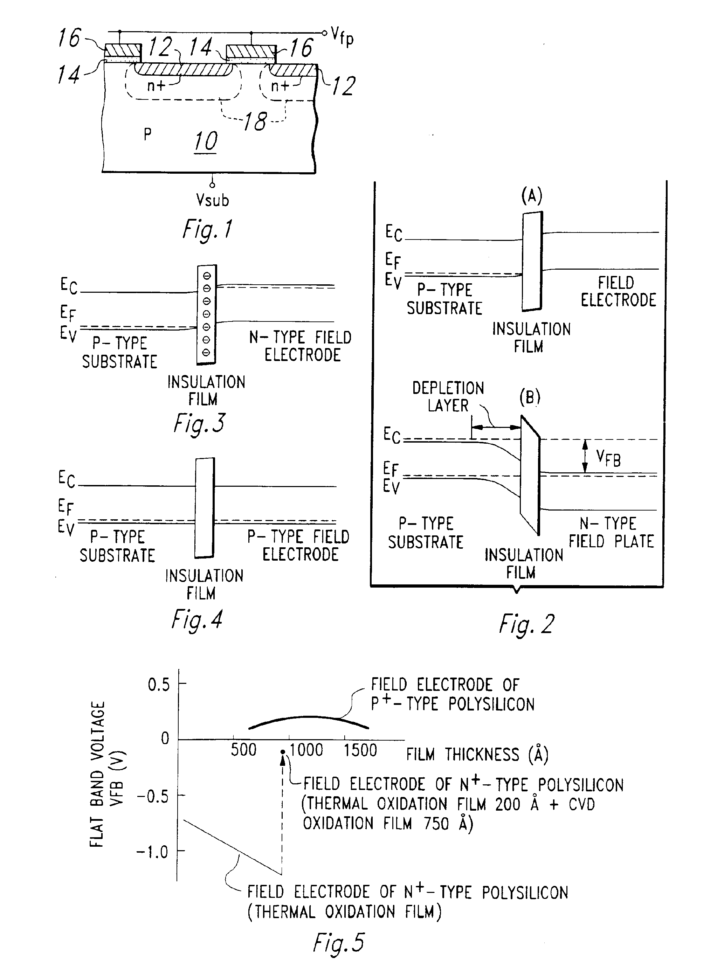

Below, application examples of said invention will be explained with reference to Figures 1-11.

Figure 1 typically shows a cross-sectional structure of a semiconductor integrated circuit based on the element separation method of said invention. In this semiconductor integrated circuit, a number of element regions 12 and 12 are formed as n⁺⁻type layers on p-type substrate 10, and insulation film 14 composed, for example, of an Si0₂ film and field electrode 16 composed, for example, of polysil icon are provided on the substrate, namely, on the element separation region between said element regions 12 and 12 so as to be superimposed. Standard substrate voltage Vsub and applied to substrate 10. Voltage Vfp, which essentially makes the surface of substrate 10j contacting insulation film 14 into the stored state, is applied to field electrode 16.

In this way, the substrate surface of the electrode separation region is made into the stored state so a depletion layer is not formed in said region. p-type substrate 10 and each of the n-type element regions 12 form pn junction, and moreover, substrate voltage Vsub functions in said pn junction as back bias (e.g., -2 V) so depletion layer 18 is formed between substrate 10 and each element region 12. However, said depletion layer 18 does not reach the element separation region.

Figure 2 shows a model of the energy band in the energy state near the substrate surface of the element separation region obtained by said invention. According to said invention, the energy band which is flat near the substrate surface or is higher in the field electrode is obtained in a case when the substrate is the p-type substrate as shown in Figure 2(A). On the contrary, as shown in Figure 2(B), negative flat band voltage VFB exists since an n-type field plate is selected with respect to the p-type substrate. Also, the potential of the field plate is selected to be a higher value than the substrate potential so a depletion layer is formed in the boundary part of the insulation film and the substrate.

Next, a concrete method for making the substrate surface of the element separation region into the stored state in said invention will be explained in Figures 3-6.

The first method is a method for including a charge with a polarity (negative when the substrate is the p-type) complying with the conductive type of the substrate in the insulation film on the element separation region as shown in Figure 3. By thus charging the insulation film, an electric field is formed in the substrate surface on the element separation region, flat band voltage VFB is cancelled with said field, and it is possible to obtain a more or less flat energy band.

In order to include a charge in the insulation film, there is a method, for example, of vapor depositing CVD an oxidation film on the thermal oxidation film. The oxidation film formed by thermal oxidation is a relatively dense amorphous layer whereas the oxidation film formed by CVD is a relatively coarse amorphous layer so many unconnected parts of crystals exist in the interface between the two and the atoms in this interface provide a negative charge. By utilizing this type of crystallographic principle, it is possible to seal in the charge in the insulation film.

One example of the results based on the first method is shown in Figure 5. This example represents test data when a field electrode was formed with n⁺⁻type polysilicon in the element separation region, and formed the insulation film by laminating a thermal oxidation film of 200 A thick and a CVD film of 750 A thick. When there is no negative charge in the insulation film, namely, when the insulation film is formed only with a thermal oxidation film it is possible to approach up to zero (V) by restoring flat band voltage VFB by about 1 V. When a more or less flat energy band is obtained by including a charge in the insulation film in this way, it is possible to make the substrate surface of the element separation region more or less in the stored state by providing a voltage which is more or less equal to the substrate voltage to the field electrode.

The second method for making the substrate surface of the element separation region into the stored state is a method which constitutes the field electrode with the same conductive type semiconductor as that of the substrate. For example, if the substrate is the p-type substrate, the field electrode is constituted with a p-type semiconductor. By doing so, a more or less flat energy band can be obtained with the field electrode with more or less the same potential as the substrate potential, as shown in Figure 4. Therefore, even in this method, it is possible to make the substrate surface in the stored state by providing a voltage which is more or less equal to the substrate voltage to the field electrode. In Figure 5, one example of the results based on the second method is also shown. The example shown in this figure is a case when the field electrode is formed with p⁺⁻type polysilicon with respect to the p-type substrate, and a positive flat band voltage VFB is obtained regardless of the film thickness.

Next, the third method is a method which forcefully applies a voltage to the field electrode to make the substrate surface of the electrode separation region into the stored state. For example, when the substrate is the p-type and the field electrode is the n-type, flat band voltage VFB is about -1 V. Therefore, when the substrate voltage is set to -2 V, it is possible to restore flat band voltage VFB and make the substrate surface in the stored state by providing voltage of -3 V which is -1 V less than the above, to the field electrode. Of course, it is possible to obtain the stored state even more reliably by making the voltage lower than -3 V, for example, a voltage of -4 V.

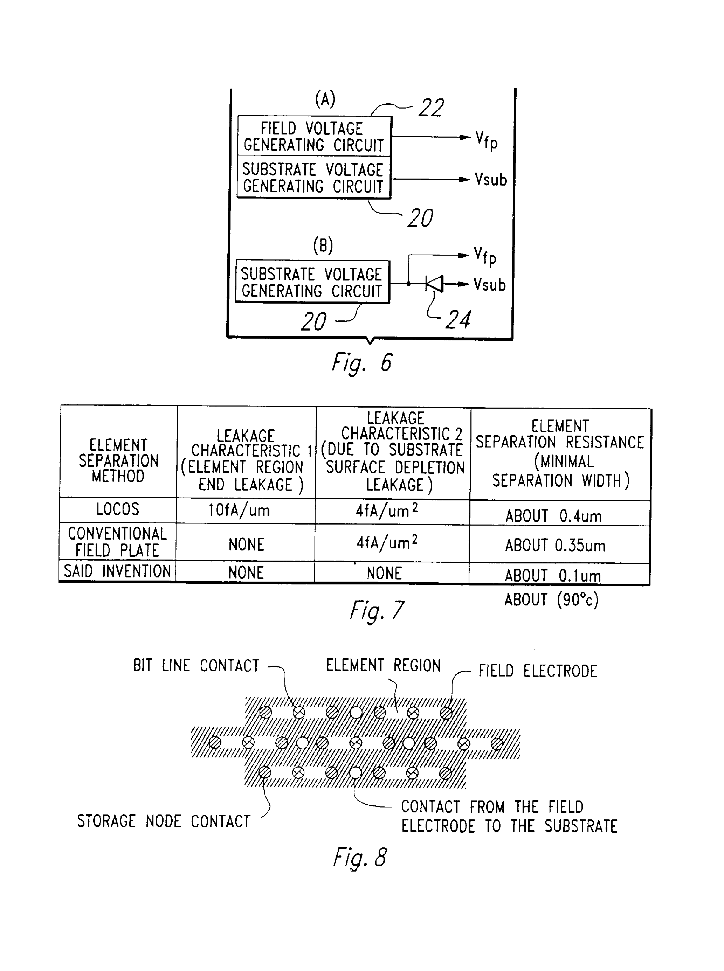

When providing a voltage different from the substrate voltage to the field electrode by complying with said third method, it is possible to provide a special voltage generating circuit 22 for the field electrode which is separate from the substrate voltage generating circuit 20 as shown in Figure 6(A) but is can be made to obtain prescribed substrate voltage Vsub and field voltage Vfp, which is higher than that by the necessary amount, by connecting one diode 24 ora a number of diodes serially to the output terminal of substrate voltage generating circuit 20 as shown in Figure 6(B).

Above, three methods for making the substrate surface of the element separating region into the stored state according to said invention were explained but, by combining these methods, the effect can be enhanced even more. For example, when the substrate is a p-type substrate, by including a negative charge in the insulation film on the element separation region by the first method and constituting the field electrode with a p-type semiconductor by the second method, it is possible to obtain the stored state even more reliably even if the third method is not used. In each of said methods, the functional results of said invention was explained regarding a case of a p-type substrate but the same functional results can be obtained even in the case of an n-type substrate. The only difference is that the potential in each part, the polarity of the charge, and the conductive type become opposite.

As noted above, according to said invention, the insulation film and the electrode were provided on the substrate of the element separation region to be superimposed, and the substrate surface of said region in the stored state is essentially made so it is possible to solve the problem of the various disadvantages found in the conventional element separation method, particularly, the problem of a leakage current from the element separation region to the substrate and the problem of a separation resistance between the elements.

First of all, in regard to the problem of a leakage current, it is not necessary to make the oxidation film on the element separation region thick like in the LOCOS method in said invention so stress is not generated in the end part of the oxidation film; thus, there is no leakage in the end part of the element region. Also, electron/hole pairs are not created since a depletion layer does not exist in the substrate surface of the element separation region thus there is no fear of leakage by the infiltration of a few carriers.

In regard to the element separation resistance, the oxidation film on the element separation region can be formed into a normal film thickness which does not have a bird's beak in said invention, so in addition to not having a restriction in the element separation characteristics originating in the bird's beak, a depletion layer does not exist in the substrate surface of the element separation region so a narrow channel effect is not created and it is possible, in principle to approach the element regions up to where they contact each other.

The test data of the element separation resistance, the leakage characteristics of the representative conventional element separation method and the method of said invention are shown in Figure 7. According to the method of said invention, it is possible to totally eliminate the leakage from the element region to the substrate and to approach the element regions up to about 0.1 f..lm. For example, in the specification of a 64 MEG [sic; 64MB] class DRAM (Dynamic Random Access Memory), leakage of less than 4 fA/cell (when it is 90°C) and a spacing between elements of about 0.35 f..lm are required, but, by using the element separation method of said invention, it is possible to accommodate said specifications with a margin.

Next, concrete examples in which the element separation method of said invention have been applied to a DRAM will be explained with reference to Figures 8-11.

Figure 8 is a top view which typically shows a layout example for executing power feeding to the field electrode easily within the memory array when applying a voltage which is equal to the substrate voltage to the field electrode using said third method in a DRAM. In Figure 8, bit line contact and storage node contact are provided within each element region. The field electrodes are arranged to surround each element region, and contact for directly coupling with the substrate through the insulation film is provided in each of said parts. Thus, by the field electrode being directly coupled through the contacts provided dis- persedly to the substrate, it is possible to stably feed a voltage which is equal to the substrate voltage to each part of the field electrode.

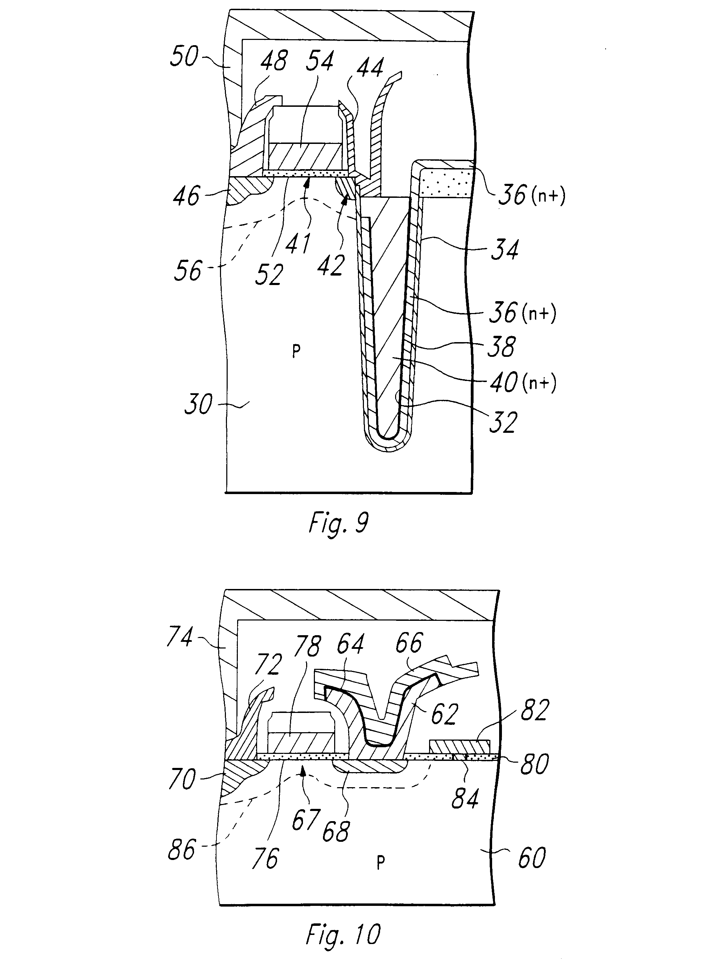

Figure 9 shows an example applied with said invention to a stack. in -trench -cell. Oxidation film 34, n⁺⁻ type field electrode 36, and dielectric film 38 are laminated on the inside wall of cylindrical groove 32 provided on p-type substrate 30, and n⁺⁻type storage electrode 40 is filled in the center core part. Field electrode 36, dielectric film 38, and storage electrode 40 form the trench capacitor. Oxidation film 34 covering the outside of said trench capacitor is an insulation film for element separation. On the side of the trench capacitor, n-type MOS transistor 41 is provided. In this MOS transistor 41, n⁺⁻type source region 42 is connected to storage electrode 40 through local interconnection 44, n⁺⁻type drain region 46 is connected to bit line 50 through local interconnection 48, and transfer gate electrode 54 on gate oxidation film 52 is formed by the word line.

In said stack in the trench cell, a voltage which is equal to or less than the substrate voltage is provided to field electrode 36 so that the surface of substrate 30 contacting oxidation film 34 takes on the stored state in accordance with said invention. Conventionally, a depletion layer was formed on the outside of the trench capacitor, a few carriers out of the generated electron/hole pairs moved along the interface of oxidation film 34 and substrate 30, and infiltrated into storage electrode 40 from source region 42 thus there was the problem of a leakage current occurring from storage electrode 40. According to said invention, a depletion layer is not formed on the outside of (around) the trench capacitor so a leakage current is not created from the storage electrode. Also, the substrate surface is in the stored state even between the adjacent memory cells so it is possible to improve the separation characteristic between elements.

Figure 10 shows an example which applied said invention to stacked cells. In the stacked cells, the capacitor of the memory cell is comprised of storage electrode 62, dielectric film 64, and capacitor electrode 66 provided to be stacked on p-type substrate 60. On one side (left side in Figure 10) of storage electrode 62, n-type MOS transistor 67 is provided. In this MOS transistor 67, source region 68 is connected to storage electrode 62, drain region 70 is connected to bit line 74 through local interconnection 72, and transfer gate electrode 78 on gate insulation film 76 is constituted with word line composed of n⁺⁻type polysilicon. The opposite side (the right side in Figure 10) of storage electrode 62 when looked at from MOS transistor 67 is the inactive region, namely, the element separation region, and on the substrate of this region, insulation film 80 composed, for example, of Si0₂ film and field electrode 82 are provided to be superimposed. In this example, contact part 84 for substrate coupling like that which is shown in Figure 8 is provided between field electrode 82 and substrate 60, and substrate voltage is applied to field electrode 82 through said contact part 84.

In said stacked cells, the substrate surface of the element separation region is made into the stored state by said first and/or second method of said invention and a depletion layer is not formed. Therefore, even in this stacked cell structure, it is possible to prevent a leakage current from the storage electrode and to improve the element separation characteristic.

Next, an application example of said invention in a MOS transistor of a DRAM will be explained with reference to Figure 11. In Figures 9 and 10, depletion layers 56 and 86 are formed in the substrate surface un- derthe word line (transfer gate) of MOS transistors 41 and 67. In the conventional DRAM, said depletion layers 56 and 86 always existed, namely, not only during write and read but even during the charge holding period. Consequently, there was the problem of causing a leakage current by a few carriers (electrons when the substrate is the p-type) out of the electron/hole pairs generated in said depletion layers infiltrating into storage electrodes 40 and 62.

According to said invention, it is possible to make the substrate surface under the transfer gate into the stored state as shown in Figure 11(B) by lowering the voltage of word lines 54 and 78 to be less than the voltage of p-type substrates 30 and 60 during precharge (charge holding state) as shown in Figure 11 (A). By it, a depletion layer is not formed in the substrate surface under the transfer gate during precharge (charge holding state), and said problem of a leakage current is eliminated. Therefore, it becomes possible to make the source and drain of the transfer gate close and can greatly improve the leakage current characteristics from the storage node and the pressure resistance characteristic between the source and drain of the MOS transistor constituting the memory cells of the DRAM.

As explained above, according to the semiconductor device and element separation method of said invention, the insulation film and the electrode are superimposed on the substrate of the element separation region and essentially made the substrate surface of the element separation region into the stored state so that a depletion layer is not formed; thus, it is possible to greatly reduce or prevent a leakage current from the element region to the substrate and at the same time realize microelement separation.

## Claims

1. A semiconductor device comprising a semiconductor region of the first conductive type,
source and drain regions of the second conductive type formed within said semiconductor region,
an insulation layer formed between said source and drain regions which covers said semiconductor region,
a gate electrode formed on said insulation layer, and
means for arranging for said first conductive type semiconductor region under said insulation layer to be in a stored state.

2. An element separation method for electrically separating a number of semiconductor elements formed above one semiconductor substrate or within the substrate, comprising the steps of:-
providing an insulation film and an electrode for superimposition on said substrate between said number of semiconductor elements, and
selecting the potential of said electrode to be such that the surface of said substrate corresponding to said electrode is essentially in a stored state.

3. An element separation method according to Claim 1, further comprising, charging said insulating layer with a charge having a polarity in compliance with the conductive type of said substrate.

4. An element separation method according to Claim 1 or Claim 2, further comprising forming said electrode with the same conductive type semiconductor material as that of said substrate.
